# EUROPÄISCHE PATENTANMELDUNG

(11) **EP 2 109 092 A2**
(43) Veröffentlichungstag der Anmeldung: **14.10.2009**
(21) Anmeldenummer: 09450073.3
(22) Anmeldetag: 03.04.2009
(51) Int. Cl.: G09G 3/32, G09F 9/33, H05B 33/08

(54) **Flachbandkabel mit Leuchtmittel**

(30) Priorität: 07.04.2008 AT 5572008
(71) Anmelder: I & T GmbH, 7011 Siegendorf (AT)
(72) Erfinder: Reiszner, Harald, Dr., 7323 Ritzing (AT)
(74) Vertreter: Wildhack & Jellinek

(57) **Zusammenfassung**

Die Erfindung betrifft ein Flachbandkabel mit einer Vielzahl von Leitungen (1), umfassend zwei Leitungen (15) zum Führen einer Versorgungsspannung und eine, insbesondere eine einzige, Busleitung (11) zum Führen eines Bussignals, und zumindest eine Ausgangsleitung (12) für die Ansteuerung von mit der jeweiligen Ausgangsleitung (12) elektrisch verbundenen Leuchtmittel (2).

Erfindungsgemäß ist vorgesehen, dass auf dem Flachbandkabel Treiberbausteine (3) angeordnet sind, wobei einer der Eingänge eines jeden Treiberbausteins (3) mit der Busleitung (11) verbunden ist, die Treiberbausteine (3) zumindest einen schaltbaren Ausgang (31) aufweisen, welcher mit jeweils einer Ausgangsleitung (12) verbunden ist, und die Ausgangsleitung (12) einzelne gegeneinander isolierte Abschnitte (121) aufweist, welche mit jeweils einem schaltbaren Ausgang (31) eines Treiberbausteins (3) elektrisch verbunden sind, und welche gegeneinander isoliert sind (Fig. 1).

## Beschreibung

Die Erfindung betrifft ein Flachbandkabel gemäß dem Oberbegriff des Anspruchs 1 und eine Bildanzeigeeinheit gemäß dem Oberbegriff des Anspruch 11.

Derartige Flachbandkabel werden, insbesondere zur elektronischen Darstellung von Bildern, insbesondere bei großen Anzeigeflächen, beispielsweise bei Werbetafeln und Lauflichtern, verwendet.

Der Erfindung liegt das Problem zugrunde, auf möglichst einfache, kostensparende Weise große Bildanzeigeeinheiten, wie z.B. Lauflichter oder Anzeigetafeln, von unterschiedlicher Größe herzustellen, welche einfach auf bestehenden Flächen montiert bzw. nachgerüstet werden können. Wichtig ist in diesem Zusammenhang eine effiziente Produktion mit geringer Ausschussrate und hoher Stabilität bzw. hohen Toleranzen gegenüber Temperatur und mechanischer Belastung, insbesondere bei temperaturbedingten Verformungen.

Ein wesentlicher Nachteil nach dem Stand der Technik ist es, dass für jede Ausgangsleitung für Leuchtmittel eine einzelne Ansteuer- bzw. Busleitung benötigt wird, wodurch die Realisierung einer derartigen Schaltung auf einem Flachbandkabel nur für eine weitaus geringere Anzahl von Leuchtmitteln möglich ist.

Ziel der Erfindung ist es, ein Flachbandkabel zu schaffen, welches die eingangs genannten Probleme überwindet.

Die Erfindung löst dieses Problem mit einem Flachbandkabel mit den Merkmalen des Anspruchs 1 sowie mit einer Bildanzeigeeinheit mit den Merkmalen des Anspruchs 11.

Ein wesentlicher Vorteil des erfindungsgemäßen Flachbandkabels besteht darin, dass eine große Anzahl von Leuchtmitteln auf einem einzigen Flachbandkabel integriert werden kann. Ferner reduziert sich die Anzahl der für die Ansteuerung der Leuchtmittel benötigten Steuer- oder Busleitungen am Kabel auf eine einzige Leitung.

Mit den Merkmalen des Anspruchs 2 wird eine Anordnung der Leuchtmitteln direkt auf den für die Stromversorgung der Leuchtmittel vorgesehenen Leitern des Flachbandkabels ermöglicht.

Mit den Merkmalen des Anspruchs 3 wird die Anzahl der benötigten Treiberbausteine bzw. Massebrücken verringert, wodurch der Aufbau des Flachbandkabels vereinfacht wird.

Mit den Merkmalen des Anspruchs 4 kann ein Flachbandkabel besonders platzsparend hergestellt werden.

Mit den Merkmalen des Anspruchs 5 kann die Leuchtkraft des erfindungsgemäßen Flachbandkabels erhöht werden. Ferner kann ein besonders großer Flächenteil des Flachbandkabels für Leuchtmittel zur Verfügung gestellt werden.

Mit den Merkmalen des Anspruchs 6 können besonders einfach und effizient Lauflichter hergestellt werden.

Die Merkmale des Anspruchs 7 vereinfachen die Fertigung und erhöhen die Stabilität eines erfindungsgemäßen Flachbandkabels.

Mit den Merkmalen des Anspruchs 8 kann der für die Ansteuerung des Flachbandkabels erforderliche Datendurchsatz verringert werden.

Anspruch 9 verringert das Datenaufkommen auf der Busleitung eines Flachbandkabels.

Eine Bildanzeigeeinheit gemäß Anspruch 10 ist besonders einfach herzustellen und kann auf beliebigen Untergründen aufgebracht werden, wobei die einzelnen, auf den Flachbandkabeln befindlichen Anzeigeelemente flexibel gegeneinander verschiebbar und somit bei insbesondere temperaturbedingten mechanischen Belastungen besondere Stabilität gewährleisten.

Die Merkmale des Anspruchs 11 ermöglichen die Ausbildung der Flachbandkabeln für die Bildung von Werbetafeln und Lauflichtern.
Fig. 1 zeigt eine einfache Ausführungsform eines Abschnitts eines erfindungsgemäßen Flachbandkabels.
Fig. 2 zeigt eine weitere Ausführungsform, bei welcher einem steuerbaren Ausgang mehrere Leuchtmittel zugeordnet bzw. nachgeschaltet sind.
Fig. 3 zeigt einen Ausschnitt einer speziellen Ausgestaltung eines erfindungsgemäßen Flachbandkabels, bei dem ein besonders hoher Anteil der Oberfläche für Leuchtmittel nutzbar ist.
Fig. 4 zeigt den strukturellen kaskadenartigen Aufbau eines Flachbandkabels.
Fig. 5 zeigt schematisch einen Treiberbaustein.
Fig. 6 zeigt schematisch den Aufbau einer erfindungsgemäßen Bildanzeigeeinheit.

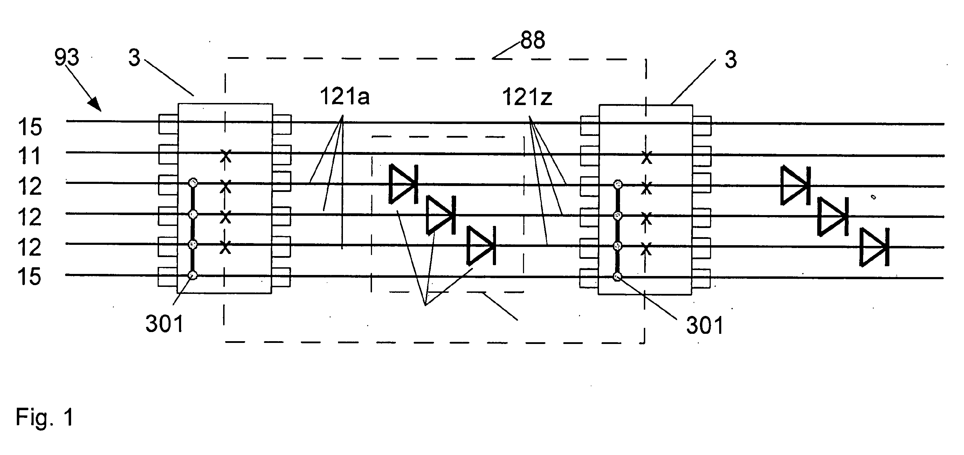

In Fig. 1 ist schematisch eine Ausführungsform der Erfindung mit einem Flachbandleiter 93 und mehreren auf diesem Flachbandleiter 93 angeordneten Treiberbausteinen 3 sowie Leuchtmitteln 2 dargestellt.

Der Flachbandleiter 93 umfasst hierbei zwei Leitungen 15 zur Führung der Versorgungsspannung, nämlich eine Masseleitung 15 VSS und eine weitere Leitung 15 VDD, welche gegenüber der Masseleitung 15 VSS auf konstantem Potential, insbesondere 12V, 24V, liegt. Ferner umfasst der Flachbandleiter 93 eine Busleitung 11, welche Steuerbefehle von einer Steuereinheit 9 (dargestellt in Fig. 7) an die einzelnen auf dem Flachbandleiter 98 angeordneten Treiberbausteine 3 weitergibt. Schließlich umfasst der Flachbandleiter 93 noch eine Anzahl von, hier drei, steuerbaren Ausgangsleitungen 12, welche die Leuchtmittel 2 ansteuern.

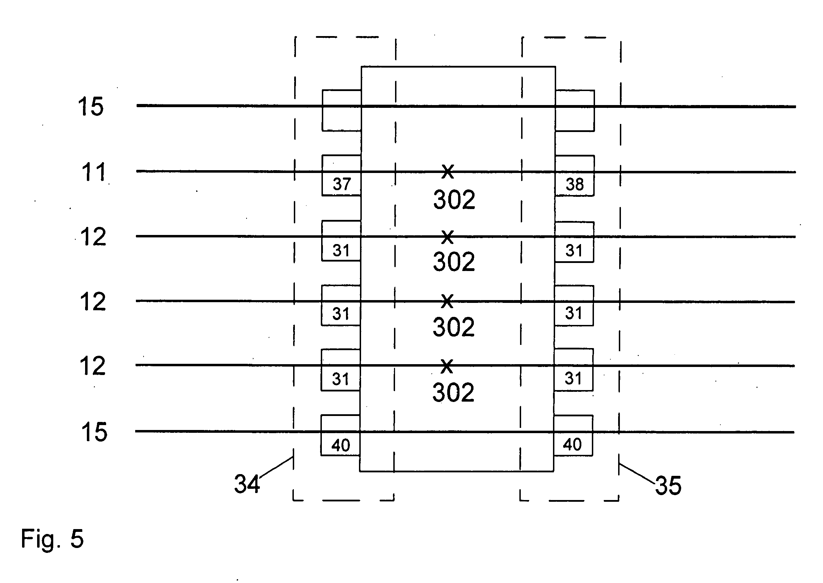

Auf dem Flachbandleiter 93 ist eine Vielzahl von Treiberbausteinen 3 und Leuchtmitteln 2 kaskadenartig angeordnet, wobei einzelnen Kaskaden 88 (s. Fig. 5) jeweils eine vorgegebene Anzahl 22 von Leuchtmitteln 2 zugeordnet ist. In dieser Ausführungsform eines erfindungsgemäßen Flachbandkabels 97 sind die Treiberbausteine 3 als Mikrochips mit zwei Anschlussreihen ausgeführt. Die Anschlüsse 34, 35 dieser beiden Anschlussreihen werden unabhängig von ihrer Lage bzw. dem Punkt des Betrachters als linke Anschlüsse 34 und rechte Anschlüsse 35 bezeichnet, wobei die linken Anschlüsse 34 eines Treiberbausteins 3 dem einen Ende des Flachbandkabels 93 näher sind und die rechten Anschlüsse 35 dem jeweils anderen Ende des Flachbandkabels 93 näher sind. Grundsätzlich dient diese Bezeichnung lediglich zur Unterscheidung der beiden Anschlussreihen und gibt sonst keinen weiteren Aufschluss über die gegenseitige Lage der beiden Anschlussreihen. In allen Fig. sind jedoch die linken Anschlüsse 34 (s. Fig. 5) auf der linken Seite des Treiberbausteins 3 und die rechten Anschlüsse 35 auf der rechten Seite des Treiberbausteins 3 dargestellt.

Die einzelnen Ausgänge 31 jedes der Treiberbausteine 3 sind mit jeweils einer der Ausgangsleitungen 12 des Flachbandkabels 93 verbunden bzw. an diese angeschlossen. Um einen Kurzschluss der einzelnen mit den Ausgangsleitungen 12 verbundenen Treiberbausteine 3 zu verhindern, werden die Ausgangsleitungen 12 im Bereich zwischen den linken Anschlüssen 34 und den rechten Anschlüssen 35 getrennt oder es ist eine Isolierung 302 vorgesehen, sodass hierdurch die jeweilige Ausgangsleitung 12 in gegeneinander isolierte Abschnitte 121 unterteilt wird.

Die Isolation 302 kann mittels Durchtrennen der Flachleiterkabel 93 oder im Zuge der Fertigung durch Ablängen der die Ausgangsleitung 12 bildenden Leiter, insbesondere Metallleiter, und anschließendem Beabstanden dieser Leiter erzielt werden, wobei die Zwischenbereiche zwischen den Leitern durch die Isolationsschicht bildendes Material aufgefüllt wird. Analog kann auch für die Busleitung 11 vorgesehen werden.

Für die Ansteuerung der Leuchtmittel 2 werden bei dieser Ausführungsform die Ausgänge 31 der rechten Anschlussreihe mit den ein vorgegebenes Bild darstellenden Steuersignalen beschaltet, welche an einen Anschluss der Leuchtmittel 2 weitergeleitet werden. Die elektrischen Signale weisen dabei einen an die Leuchtmittel 2 angepassten Signalpegel auf, wobei gegebenenfalls in oder auf den Treiberbausteinen 3 Strombegrenzungsschaltungen oder Vorwiderstände zur Begrenzung der maximalen Stromaufnahme der Leuchtmittel 2 vorgesehen sind.

Werden als Leuchtmittel 2 Leuchtdioden verwendet, so wird die Anode der jeweiligen Leuchtdiode 2 an den jeweiligen Ausgang 31 der linken Anschlussreihe 34 angeschlossen und die Kathode an den Ausgang 31 der rechten Anschlussreihe 35 angeschlossen.

Die Ausgänge 31 aus der Reihe der linken Anschlüsse 34 wird in diesem Fall mit der Masseleitung VSS, 15 kurzgeschlossen. Um den Stromfluss durch das Leuchtmittel 2 zu ermöglichen, ist die Ausgangsleitung 12 zwischen den beiden Anschlüssen des Leuchtmittels 2 in zwei Bereiche 121a, 121z, nämlich einen Anschlussbereich 121a und einen Massebereich 121z unterteilt. Ein Anschluss 121a ist hierbei an einen an einem rechten Anschluss 35 angeordneten Ausgang 31 eines Treiberbausteins 3 angeschlossen.

Derjenige mit der selben Ausgangsleitung 12 verbundene und an dem linken Anschluss des benachbart angeordneten Treiberbausteins 3' vorgesehene Ausgang 31 ist mit einem Massebereich 121z verbunden bzw. in diesen angeschlossen. Das jeweilige Leuchtmittel 2 ist mit einem seiner Anschlüsse an den Anschlussbereich 121 a, sowie mit dem jeweils anderen Anschluss am Massebereich 121z angeschlossen. Bei bipolaren Leuchtmitteln 2, insbesondere Leuchtdioden, kann die Ansteuerungsschaltung derart ausgebildet werden, dass die Kontaktierung entweder an der Anode oder an der Kathode erfolgt, während der jeweils andere Pol des Leuchtmittels 2 auf Massepotential oder auf der Betriebsspannung liegt.

Jeder der auf dem Flachbandkabel 93 angeordneten Treiberbausteine 3 weist einen Buseingang 37, sowie einen Busausgang 38 auf, wobei der Buseingang 37 in dieser konkreten Ausführungsform als linker Anschluss 34 des Treiberbausteins 3 ausgebildet ist und der Busausgang 38 als rechter Anschluss 35 des Treiberbausteins 3 ausgebildet ist. Die Busleitung 11 ist zwischen dem Buseingang 37 und dem Busausgang 38 unterbrochen, wobei im Treiberbaustein 3 zwischen dem Buseingang 37 und dem Busausgang 38 eine Logik zur automatischen Adressierung der Treiberbausteine 3 vorgesehen sein kann.

Zum Adressieren der einzelnen auf einem Flachbandkabel befindlichen Treiberbausteine 3 kann beispielsweise wie folgt vorgegangen werden: Zunächst sind die Buseingänge 37 und die Busausgänge aller Treiberbausteine getrennt, sodass nur derjenige Treiberbaustein 3, welcher an einem Ende des Flachbandkabels liegt, angesprochen werden kann. Diesem wird eine vorgegebene Adresse zugewiesen. Anschließend schaltet dieser seinen Buseingang 37 an den Busausgang 38 durch, wodurch auch der jeweils nächste Treiberbaustein 3 an die Busleitung gekoppelt ist. Beim nächsten Adressierungsvorgang wird diesem Treiberbaustein 3 eine Adresse zugewiesen. Dieser Vorgang wird anschließend wiederholt, bis alle an der Busleitung liegenden Treiberbausteine 3 eine Adresse aufweisen. Anschließend können einzelne Treiberbausteine 3 über die Busleitung angesprochen werden, was die Steuerung der Leuchtmittel 2 ermöglicht.

Um die jeweiligen schaltbaren Ausgänge 31, welche als linke Anschlusse 34 auf dem Treiberbaustein 3 ausgebildet sind, möglichst platzsparend zu gestalten, kann vorgesehen werden, dass eine Überbrückungsleitung 301 in den Treiberbaustein 3 integriert wird, welche diese Anschlüsse direkt mit der Masseleitung 15/VSS oder aber auch mit der anderen Leitung 15/VDD zum Führen einer Versorgungsspannung kurzgeschlossen bzw. fest verdrahtet wird. Falls eine derartige Überbrückungsleitung 301 auf dem Treiberbaustein in Form eines Mikrochips realisiert werden soll, ist diese Leitung an die Stromaufnahme aller von dem jeweiligen Treiber angesteuerten Leuchtmittel 2 anzupassen.

Um mittels der in Fig. 1 dargestellten Schaltung die Leuchtmittel 2 gemäß den an der Busleitung 11 anliegenden Steuersignalen zu schalten, wird das jeweils an der Busleitung 11 anliegende Steuersignal über den jeweiligen Buseingang 37 in die einzelnen Treiberbausteine 3 geleitet, wobei jeder der Treiberbausteine 3 eine programmierbare, logische Schaltung aufweist, welche die Steuersignale aufbereitet, zwischenspeichert und gegebenenfalls in Steuerinformationen an den schaltbaren Ausgängen 31 weiterleitet. Das Steuersignal umfasst Informationen, insbesondere Adressinformationen, darüber, welcher Treiberbaustein 3 für die nachfolgende Aktion ausgewählt ist. Ferner umfasst die an der Busleitung 11 anliegende Steuerinformation die vorgegebenen Helligkeitsinformationen für die einzelnen vom ausgewählten Treiberbaustein 3 zu steuernden Leuchtmittel 2. Die Helligkeit der Leuchtmittel 2 kann vorzugsweise dadurch erzielt werden, dass die Leuchtmittel 2, insbesondere Leuchtdioden, von einem im Treiberbaustein 3 generierten Pulsweitenmodulationssignals (PWM) gespeist werden. Hierbei wird ein Signal mit einer Frequenz in 100 Hz bis 10 KHz-Bereich verwendet, wobei das Verhältnis zwischen der Zeit, in welchem ein High-Signalpegel vorliegt und den Zeiten, in welchen Low-Signalpegel vorliegt durch den Treiberbaustein 3 reguliert wird und wodurch die Helligkeit der Leuchtmittel 2 geregelt werden kann.

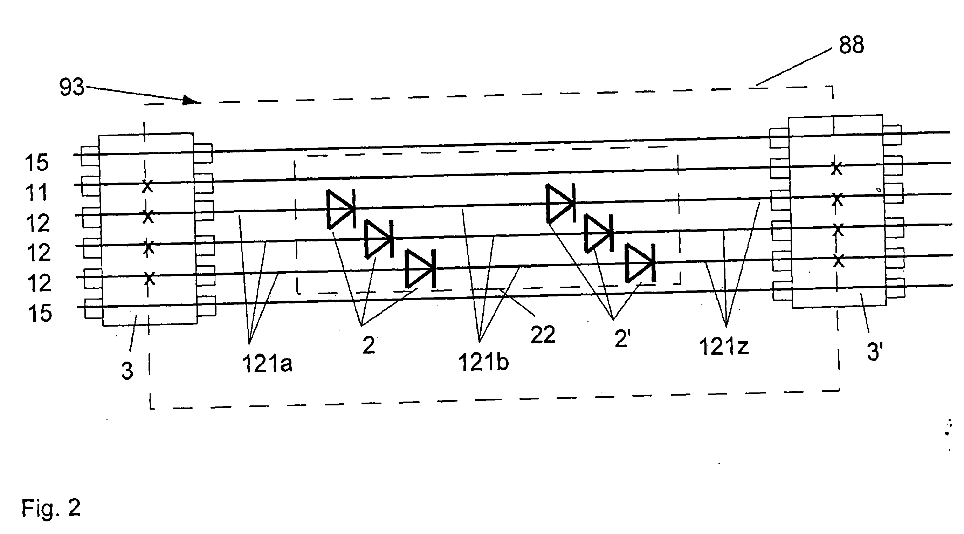

Fig. 2 zeigt eine ähnliche Ausführungsform der Erfindung, wie in Fig. 1 mit dem Unterschied, dass zwischen zwei Treiberbausteinen 3, 3' auf jeder der Ausgangsleitungen 12 jeweils zwei Leuchtmittel 2 angeordnet sind. Der jeweilige Abschnitt 121 der Ausgangsleitung 12 wird somit in drei voneinander isolierte Bereiche 121 a, 121 b, 121 z unterteilt, wobei der erste Bereich 121 a mit dem schaltbaren Ausgang 31 des jeweiligen Treiberbausteins 3 elektrisch verbunden bzw. an diesen angeschlossen ist, der letzte Bereich 121z an die an den linken Anschlüssen 34 angeordneten Ausgänge 31 des weiteren Treiberbausteins 3' angeschlossen ist. An jeder der Ausgangsleitungen 12 sind jeweils zwei Leuchtmittel 2 angeordnet, wobei ein Leuchtmittel 2 mit dem einen Anschluss an dem ersten Bereich 121a der Ausgangsleitung 12 angeschlossen ist und mit einem jeweiligen anderen Anschluss an einem zweiten Abschnitt 121b angeschlossen ist, welcher sich zwischen dem ersten Bereich 121 a und dem letzten Bereich 121z befindet und gegenüber diesen beiden Bereichen 121a, 121z isoliert ist. Ferner ist an jeder der Ausgangsleitungen 12 ein weiteres Leuchtmittel 2' angeordnet, welches mit seinem einen Eingang am zweiten Bereich 121 b der jeweiligen Ausgangsleitung 12 angeschlossen ist und mit seinem jeweils anderen Anschluss am letzte Bereich 121z der jeweiligen Ausgangsleitung 12 angeschlossen ist.

Bei einer derartigen Ausgestaltung des erfindungsgemäßen Flachbandkabels 93kann die mit den Leuchtmitteln 2 erzielte Helligkeit verdoppelt werden. Analog können Ausführungsformen für mehrere, an einem Abschnitt 121 einer Ausgangsleitung 12 angeordneten Leuchtmittel betrieben werden, indem dieser Abschnitt 121 in eine Vielzahl von Bereichen 121a...121z unterteilt wird und über die Leuchtmittel 2, welche an einem isolierten Abschnitt 121 angeordnet sind, eine durchgehende, elektrische Verbindung zwischen dem ersten Bereich 121a, über weitere dazwischenliegende Bereiche 121b...121y und dem letzten Bereich 121z hergestellt wird.

Bevorzugterweise kann vorgesehen werden, dass Leuchtmittel 2 mit der Ausgangsleitung 12 mechanisch verbunden und elektrisch gekoppelt sind. Dies kann insbesondere durch Löten und/oder Verpressen und/oder Prägen erfolgen.

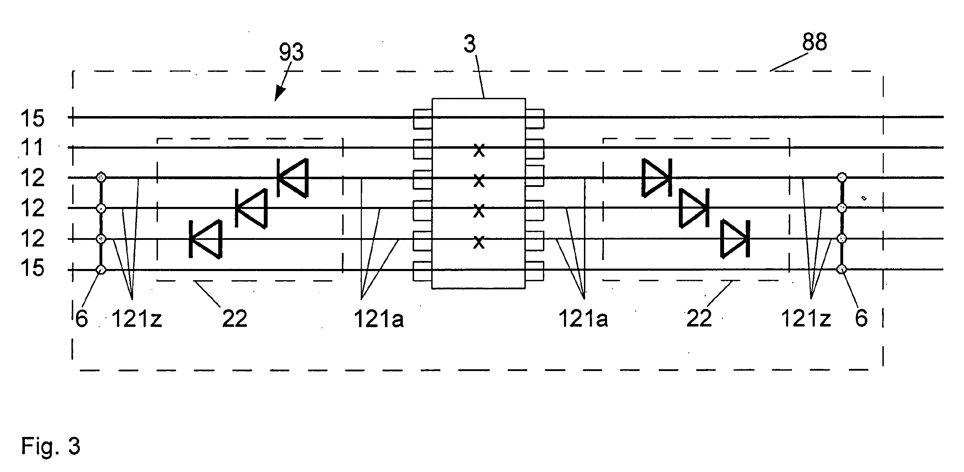

Eine weitere Ausführungsform der Erfindung ist in Fig. 3 dargestellt. Diese Ausführungsform hat den wesentlichen Vorteil, dass eine größere Anzahl von Leuchtmitteln 2 auf einem Flachbandkabel 93 angebracht werden kann, bzw. das Verhältnis der den Leuchtmitteln 2 zur Verfügung stehenden Fläche zur Gesamtfläche des Flachbandkabels 93 vergrößert wird.

In dieser Ausführungsform ist vorgesehen, dass sowohl schaltbare Ausgänge 31, welche am linken Anschluss eines Treiberbausteins 2 angeordnet sind als auch schaltbare Ausgänge 31, welche am rechten Anschluss 35 eines Treiberbausteins 3 angeordnet sind, separat durch eine Ansteuerung über die Busleitung 11 schaltbar sind. Jedem dieser Ausgänge ist ein Abschnitt 121 der Ausgangsleitung zugeordnet, welche gegenüber dem übrigen Abschnitt 121 isoliert ist. Jeder dieser isolierten Abschnitte 121 umfasst zwei gegeneinander isolierte Bereiche 121a, 121z, wobei der erste Bereich 121a jeweils mit einem schaltbaren Ausgang 31 des Treiberbausteins 3 verbunden bzw. an diesen angeschlossen ist. Zwischen jeweils zwei benachbarten Treiberbausteinen 3, 3' ist eine leitende Brücke 6 vorgesehen, welche jeweils den letzten Bereich 121z mit einer Leitung 15 zum Führen der Versorgungsspannung, je nach Treiberauslegung mit der Masseleitung 15/VSS, oder der Versorgungsspannleitung 15NDD verbindet. Ferner ist in dieser speziellen Ausführungsform vorgesehen, dass für zwei benachbarte Treiberbausteine 3 ein gemeinsamer letzter Bereich 121z vorgesehen ist, an welchen die leitende Brücke 6 angeschlossen ist, welche den letzen Bereich 121 z mit der Masseleitung 15/VSS verbindet. Alternativ kann vorgesehen werden, dass auch für diese Ausführungsform eine Vielzahl von Leuchtmitteln 2 zwischen dem Ausgang 31 und der leitenden Brücke 6 angeordnet sein können, wobei derjenige, an den Ausgang 31 angeschlossene isolierte Abschnitt in eine Anzahl von n+1 Bereichen unterteilt wird, wobei n die Anzahl der auf einem isolierten Abschnitt befindlichen Leuchtmittel 2 entspricht.

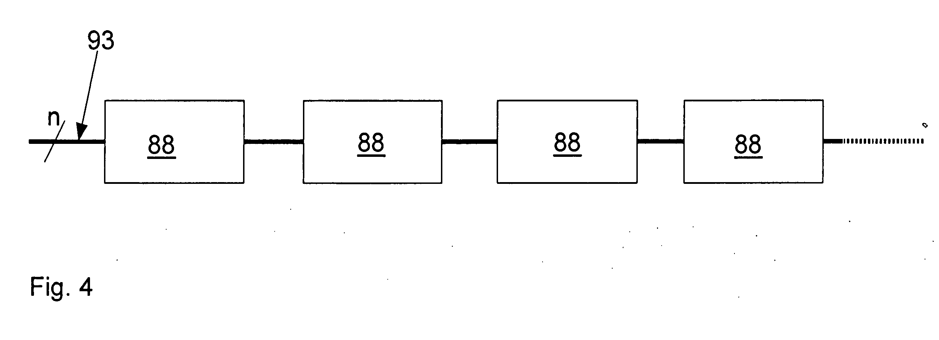

Fig. 4 zeigt den Kaskadenartigen Aufbau eines Flachleiterkabels. Die einzelnen Kaskaden 88 sind gleichartig aufgebaut und umfassen Treiberbausteine 3 und Leuchtmittel 2.

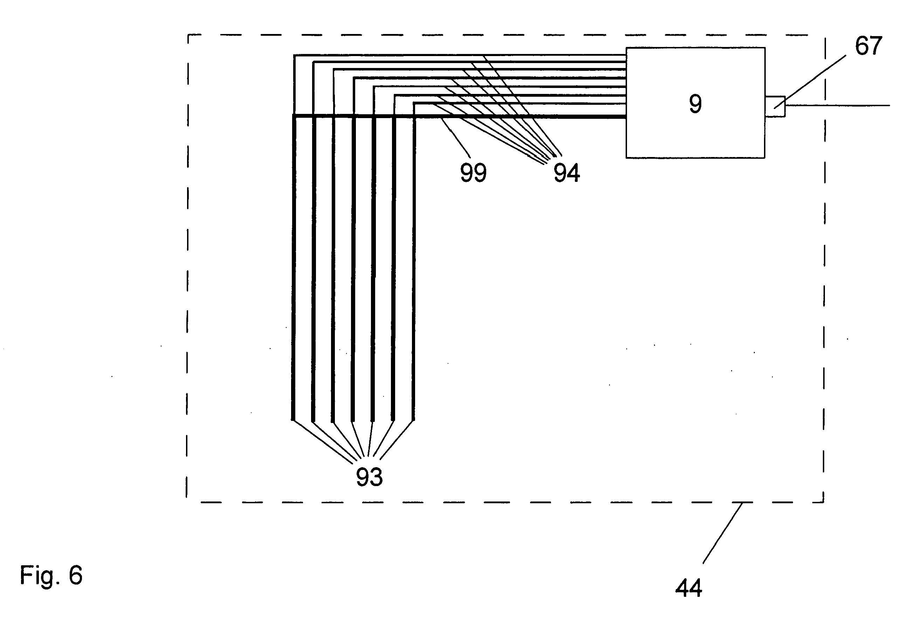

Fig.6 zeigt schematisch den Aufbau der äußeren Anschlüsse eines Treiberbausteins 3, sowie das Flachbandkabel 97 im Bereich der Anschlüsse eines Treiberbausteins 3.

Der Treiberbaustein 3 ist zweireihig ausgeführt, das heißt er umfasst zwei Reihen von Anschlüssen, wobei jeweils ein Anschluss einer Reihe mit jeweils einem der Leiter des Flachbandkabels 93 elektrisch verbunden bzw. an diesem angeschlossen ist. Die Anschlüsse des Treiberbausteins 3 einer Reihe werden als linke Anschlüsse 34 bezeichnet, die Anschlüsse der anderen Reihe werden als rechte Anschlüsse 35 bezeichnet. Ferner umfasst der Treiberbaustein 3 eine Anzahl von schaltbaren Ausgängen 31, welche sowohl an der Reihe der linken Ausgänge 34 als auch an der Reihe der rechten Ausgänge 35 angeordnet sind. Zwischen den schaltbaren Ausgängen 31 der linken Anschlussreihe und den schaltbaren Ausgängen 31 der rechten Anschlussreihe sind Unterbrechungen 302 der jeweiligen Ausgangsleitung 12 vorgesehen, welche die Ausgangsleitung 12 in zwei voneinander isolierte Abschnitte 121 unterteilen. Ferner weist der Treiberbaustein 3 Spannungsversorgungsanschlüsse 39, 40 auf, welche jeweils mit einer der beiden Leitungen 15 zum Führen einer Versorgungsspannung verbunden sind. Weiters weist der Treiberbaustein 3 einen Buseingang 37 und einen Busausgang 38 auf, wobei der Buseingang 37 auf einem linken Anschluss implementiert oder angeordnet ist und der Busausgang 38 auf einem rechten Anschluss implementiert oder angeordnet ist. Beide Anschlüsse sind an die Busleitung 11 des Flachbandkabels 93 angeschlossen. Im Bereich zwischen dem Buseingang 37 und dem Buseingang 38 ist am Flachbandkabel 93 eine Unterbrechung 302 vorgesehen, wodurch der Buseingang und der Busausgang 38 voneinander entkoppelt bzw. gegeneinander isoliert werden.

Alternativ kann ein Treiberbaustein 3 auf eine Leiterplatte aufgelötet werden, welche Anschlüsse aufweist mit denen diese an die Leitungen des Flachbandkabels 93 angeschlossen bzw. angelötet werden kann. Auf der Leiterplatte können beispielsweise die zur Strombegrenzung für die Leuchtmittel 2 verwendeten Widerstände angeordnet werden. Selbstverständlich ist es auch möglich, dass anstelle der Strombegrenzungswiderstände auch einstellbare Stromquellen für die Leuchtmittel verwendet werden. Dies ist insbesondere dann von Vorteil, wenn als Leuchtmittel Leuchtdioden eingesetzt werden. Somit ist ein Betrieb ohne Strombegrenzungswiderstände möglich. Ferner kann ein zur Stabilisierung der Versorgungsspannung dienender Kondensator mit jeweils einem seiner Anschlüsse an jeweils einem der Anschlüsse 39, 40 zur Spannungsversorgung angeschlossen sein. Ferner können auf der Leiterplatte auch weitere Anschlüsse zur Programmierung des Treiberbausteins vorgesehen sein. In diesem Fall ist eine programmierbare, logische Schaltung, insbesondere in Form eines Mikrochips, an die Leiterplatte angeschlossen, insbesondere verlötet. Die jeweilige Leiterplatte ist dabei selbst mit dem Flachbandkabel verlötet, wobei durch weitere mechanische Befestigungsmittel, insbesondere Klebstoff, zusätzlicher Halt erzielt wird.

Weiters ist es auch möglich, die Treiberbausteine 3 auf das Flachbandkabel 93 aufzukleben oder aufzupressen oder aufzuprägen, wobei alle an den Treiberbausteinen 3 angeordneten Anschlüsse mit den Leitungen des Flachbandkabels 93 verbunden sind. Besonders robuste Flachbandkabel 93 können dadurch erzielt werden, dass die Treiberbausteine 3 mittels dem die Isolierschicht des Flachbandkabels 93 bildenden Kunststoffs mit dem Flachbandkabel 93 verklebt oder von diesem, insbesondere vollständig umgeben sind. Die Anschlüsse 34, 35 der Treiberbausteine sind, insbesondere so ausgelegt, dass eine direkte Verdrahtung auf dem Flachbandkabel möglich ist. Hierbei sind die als Anschlusspads ausgeführten Anschlüsse 34, 35 des Treiberbausteins so beabstandet, dass diese bei Anordnung des Treiberbausteins oberhalb des Flachbandleiters direkt oberhalb der einzelnen Leiter zu liegen kommen. Dadurch ist eine direkte Verdrahtung der Anschlusspads mit dem Flachbandkabel, beispielsweise durch Auflöten möglich. Die Unterbrechungen 302 können dabei unmittelbar vor dem Auflöten der Treiberbausteine, insbesondere durch Stanzen gefertigt werden.

Die Treiberbausteine 3 sind vorteilhafterweise als integrierte, programmierbare, logische Schaltungen ausgebildet sein. Die Treiberbausteine 3 sind einzeln adressierbar, das heißt sie weisen eine fixe Adresse auf, mittels welcher sie von einer Zentralsteuereinheit einzeln angesteuert werden können. Der Treiberbaustein 3 kann einen weiteren vom Flachbandkabel 93 elektrisch entkoppelte Anschluss zur Programmierung aufweisen. So können bereits bei der werksmäßigen Fertigung den einzelnen Treiberbausteinen 3 bestimmte Sequenzen oder Leuchtfolgen zugeordnet werden, welche anschließend mittels einfacher Steuerbefehle über die Busleitung 11 abgerufen werden können. Somit reduziert sich der Steuerungsaufwand erheblich, wodurch die Datenraten über die Busleitung 11 reduziert wird.

Weiters kann auch, wie oben beschrieben, ein Verfahren zur automatischen Adressierung der Treiberbausteine angewendet werden.

Zur weiteren Reduktion des Steuerungsaufwandes kann vorgesehen werden, dass mittels eines einzigen Befehls, nämlich eines Broadcast-Befehls alle Treiberbausteine zur Durchführung eines vorgegebenen, bereits eingespeicherten Befehls getriggert werden können.

Fig. 6 zeigt schematisch eine Bildanzeigeeinheit 44 umfassend eine Vielzahl Flachbandkabeln 93, sowie eine Steuereinheit 9. Die Steuereinheit 9 weist einen Signaleingang 67 für ein Bildsignal auf und wandelt dieses Bildsignal in Steuerinformationen um, welche sie über die Steuerleitungen 94 an die Busleitungen 11 der einzelnen Flachbandkabel 93 abgibt. Die Steuereinheit 9 weist dabei so viele Anschlüsse auf, wie Flachbandkabel 93 verwendet werden. Jede der Steuerleitungen 94 ist dabei an eine Busleitung 11 eines Flachbandkabels 93 angeschlossen. Zur Versorgung der einzelnen Flachbandkabel 93 mit elektrischer Energie ist von der Steuereinheit 9 ein Versorgungskabel 94 vorgesehen, welches an die Leitungen 15 zum Führen der Versorgungsspannung jedes der Flachbandkabel 93 angeschlossen ist.

Die Bildanzeigeeinheit 44 umfasst vorteilhafterweise eine Anzahl von Flachbandkabeln 93, welche vorzugsweise gleich aufgebaut sind und die selbe Anzahl von Treiberbausteinen 3, sowie Leuchtmitteln 2 aufweisen. Die Leuchtmittel 2 und Treiberbausteine 3 haben denselben Abstand auf den Flachbandkabeln 93 zueinander. Vorteilhafterweise kann vorgesehen werden, dass die Leuchtmittel 2 auf den Flachbandkabeln 93 in Form einer Matrix angeordnet sind. Die Flachbandkabel 93 sind dabei parallel und entlang einer geraden Linie ausgerichtet, wobei der Abstand der einzelnen Flachbandkabel 93 zueinander für alle benachbarten Flachbandkabel 93 gleich ist. Durch die große Flexibilität der Flachbandkabel 93 können beliebige Oberflächenformen mit einer Matrix, umfassend mehrere Flachbandkabel 93 ausgebildet werden. Weiters kann vorgesehen werden, dass die Flachbandkabel 93 auf einer ebenen Fläche angeordnet sind, wobei zu Verbesserung der Stabilität der Bildanzeigeeinheit 44 eine Rückwand vorgesehen ist, an welcher die Flachbandkabel 93 angeordnet, insbesondere aufgeklebt sind.

Die in den Fig. 1, 2, 3 und 5 dargestellten Flachbandkabel bzw. Treiberbausteine 3 weisen jeweils drei schaltbare Ausgänge 31, insbesondere an der rechten Anschlussreihe, auf. Eine derartige Anordnung ist, insbesondere dann sinnvoll, wenn die drei Leuchtmittel 2, wie in Fig. 1 dargestellt, unterschiedliche Farben, insbesondere die Farben Rot, Grün und Blau aufweisen.

## Patentansprüche

1. Flachbandkabel mit einer Vielzahl von Leitungen (1), umfassend
a) zwei Leitungen (15) zum Führen einer Versorgungsspannung, insbesondere eine Masseleitung (VSS) und eine Versorgungsspannungsleitung (VDD), und
b) eine, insbesondere eine einzige, Busleitung (11) zum Führen eines Bussignals, und
c) zumindest eine Ausgangsleitung (12), insbesondere drei Ausgangsleitungen (12), für die Ansteuerung von mit der jeweiligen Ausgangsleitung (12) elektrisch verbundenen Leuchtmittel (2),
**dadurch gekennzeichnet, dass**
d) auf dem Flachbandkabel Treiberbausteine (3) angeordnet sind, wobei einer der Eingänge eines jeden Treiberbausteins (3) mit der Busleitung (11) verbunden ist,
e) die Treiberbausteine (3) zumindest einen schaltbaren Ausgang (31) aufweisen, welcher mit jeweils einer Ausgangsleitung (12) verbunden ist, und
f) die Ausgangsleitung (12) einzelne gegeneinander isolierte Abschnitte (121) aufweist, welche mit jeweils einem schaltbaren Ausgang (31) eines Treiberbausteins (3) elektrisch verbunden sind, und welche gegeneinander isoliert sind.

2. Flachbandkabel gemäß Anspruch 1, **dadurch gekennzeichnet, dass**
a) die einzelnen gegeneinander isolierten Abschnitte (121) der Ausgangsleitung (12) in mehrere, insbesondere zwei, elektrisch gegeneinander isolierte Bereiche (121a, ..., 121z) unterteilt sind, umfassend
einen ersten Bereich (121 a), der mit dem schaltbaren Ausgang (31) des jeweiligen Treiberbausteins (3) elektrisch verbunden ist, und
einen letzten Bereich (121z), der mit einer der zwei Leitungen (15) zum Führen einer Versorgungsspannung verbunden ist, wobei
die Leuchtmittel (2) an jeweils einem ihrer Anschlüsse zwei benachbart angeordnete Bereiche (121a, ... 121z) verbinden, und
über die Leuchtmittel (2) eine durchgehende elektrische Verbindung zwischen dem ersten Bereich (121a), gegebenenfalls über weitere dazwischenliegende Bereiche, und dem letzten Bereich (121z) hergestellt ist, wobei
gegebenenfalls die Leuchtmittel (2) mit der jeweiligen Ausgangsleitung (12) mechanisch verbunden, insbesondere verpresst oder geprägt oder verlötet, sind.

3. Flachbandkabel gemäß einem der vorangehenden Ansprüche, **dadurch gekennzeichnet, dass**
a) die Treiberbausteine (3) als Mikrochips umfassend zwei Reihen von Anschlüssen, nämlich rechte Anschlüsse (34) und linke Anschlüsse (35), ausgeführt sind, wobei jeweils ein rechter Anschluss (34) und jeweils ein linker Anschluss (35) mit der jeweiligen Leitung (1) des Flachbandkabels verbunden sind, und
b) im Bereich zwischen den Anschlüssen des Treiberbausteins (3) eine Durchtrennung der Ausgangsleitung (12), gegebenenfalls auch der Busleitung (11), zwecks Isolierung und Bildung von Abschnitten (121) ausgebildet ist, wobei die rechten Anschlüsse (34) und/oder die linken Anschlüsse (35) welche an die Ausgangsleitungen (12) angeschlossen sind, die schaltbaren Ausgänge (31) bilden.

4. Flachbandkabel gemäß Anspruch 3, **dadurch gekennzeichnet, dass**
a) eine Vielzahl von Treiberbausteinen (3) auf dem Flachbandkabel angeordnet ist, wobei für jeden Treiberbaustein (3) die jeweils nächstgelegenen Treiberbausteine (3) als benachbart angesehen werden,
b) der letzte Bereich (121z) elektrisch mit einem weiteren, am Flachbandkabel benachbart angeordneten Treiberbaustein (3') verbunden ist, und
b) in einem zu diesem Treiberbaustein (3) benachbarten Treiberbaustein (3') zumindest eine, insbesondere alle, Ausgangsleitungen (12) über Anschlüsse (34, 35) mit einer der beiden Leitungen (15) zum Führen der Versorgungsspannung verbunden sind.

5. Flachbandkabel gemäß Anspruch 3, **dadurch gekennzeichnet, dass**
a) beide Reihen von Anschlüssen (34, 35) schaltbare Ausgänge (31) für Leuchtmittel (2) aufweisen,
b) jeder der schaltbaren Ausgänge (31) an einem isolierten Abschnitt (121) der Ausgangsleitung (12) vorgesehen ist,
c) dieser Abschnitt (121) der Ausgangsleitung (12) in eine Vielzahl von, insbesondere zwei, Bereiche (121a, ... 121z) unterteilt ist,
d) zwischen jeweils zwei benachbarten Treiberbausteinen (3) eine leitende Brücke (6) vorgesehen ist, welche jeweils den letzten Bereich (121z) mit einer der zwei Leitungen (15) zum Führen der Versorgungsspannung verbindet,
e) wobei gegebenenfalls ein gemeinsamer letzter Bereich (121z) für zwei benachbarte Treiberbausteinene (3) vorgesehen ist, und
f) über die Leuchtmittel (2) eine durchgehende elektrische Verbindung zwischen dem ersten Bereich (121a), gegebenenfalls über weitere dazwischenliegende Bereiche (121b, ... 121y), und dem letzten Bereich (121z) hergestellt ist.

6. Flachbandkabel gemäß einem der vorangehenden Ansprüche, **dadurch gekennzeichnet, dass**
a) die Busleitung (11) zwischen dem rechten Anschluss (34) und dem linken Anschluss (35) eines Treiberbausteins (3) unterbrochen ist, und
b) jeder Treiberbaustein einen Buseingang (37) und einen Busausgang (38) aufweist, wobei zwischen dem Buseingang (37) und dem Busausgang (38) eine Adressierungslogik zwischengeschaltet ist und der Busausgang (38) mit dem jeweils anderen vom Buseingang (37) elektrisch isolierten Bereich der Busleitung (11) elektrisch verbunden ist.

7. Flachbandkabel gemäß einem der vorangehenden Ansprüche, **dadurch gekennzeichnet, dass**
a) die Treiberbausteine (3) eine Leiterplatte (44) und einen auf die Leiterplatte (44) aufgedruckten Mikrochip umfassen, wobei die Leiterplatte (44) Anschlüsse aufweist, welche an die Leitungen des Flachbandkabels angeschlossen, insbesondere angelötet sind, und/oder
b) die Treiberbausteine (3) auf das Flachbandkabel, insbesondere heiß, aufgeklebt oder aufgepresst oder aufgeprägt sind, wobei alle auf den Treiberbausteinen (3) angeordneten Anschlüsse (31) mit den Leitungen des Flachbandkabels verbunden sind, und/oder
c) die Treiberbausteine (3) mittels dem, das die Isolierschicht des Flachbandkabels bildenden Kunststoffs mit dem Flachbandkabel verklebt oder von diesem, insbesondere vollständig, umgeben sind.

8. Flachbandkabel gemäß einem der vorangehenden Ansprüche, **dadurch gekennzeichnet, dass** die Treiberbausteine (3) als integrierte programmierbare logische Schaltungen ausgebildet sind, welche gegebenenfalls eine weitere, von den Leitungen des Flachbandkabel elektrisch entkoppelte Anschlüsse zur Programmierung aufweisen.

9. Flachbandkabel gemäß einem der vorangehenden Ansprüche, **dadurch gekennzeichnet,**
**dass** in den Treiberbausteinen (3) Sequenzen von Steuersignalen gespeichert sind und diese Sequenzen mittels Steuerbefehle über die Busleitung (11) zur Ansteuerung der Leuchtmittel (2) abrufbar sind.

10. Bildanzeigeeinheit umfassend eine Vielzahl von in einer vorgegebenen Form angeordneten Flachbandkabeln (93) gemäß einem der vorangehenden Ansprüche sowie eine Steuereinheit (9), **dadurch gekennzeichnet, dass**
a) die Steuereinheit (9) ein Signaleingang (67) für ein Bildsignal aufweist, und
b) eine Steuereinheit (9) vorgesehen ist, welche die im Bildsignal übermittelten Bildinformationen in Steuerbefehle umwandelt und an die jeweiligen Busleitungen (11) der Flachbandkabel (93) abgibt.

11. Bildanzeigeeinheit gemäß Anspruch 10, **dadurch gekennzeichnet, dass**
a) jedes Flachbandkabel (93) dieselbe Anzahl von Treiberbausteinen (3) sowie Leuchtmittel (2) aufweist, und/oder
b) die Leuchtmittel (2) und Treiberbausteine (3) denselben Abstand auf den Flachbandkabeln (93) zueinander aufweisen, und/oder
c) die Flachbandkabel (93) parallel und entlang einer geraden Linie, insbesondere mit gleichem Abstand zueinander, angeordnet sind, und/oder
d) die Flachbandkabel (93) in einer Ebene angeordnet sind, und/oder
e) die Leuchtmittel (2) der Flachbandkabel in Form einer Matrix angeordnet sind.
